(19) Europäisches Patentamt
European Patent Office
Office européen des brevets

(11) **EP 2 075 845 A1**

(12) **DEMANDE DE BREVET EUROPEEN**

(43) Date de publication:
**01.07.2009 Bulletin 2009/27**

(51) Int Cl.:
**H01L 27/146** (2006.01)

(21) Numéro de dépôt: **08305987.3**

(22) Date de dépôt: **19.12.2008**

(84) Etats contractants désignés:
**AT BE BG CH CY CZ DE DK EE ES FI FR GB GR HR HU IE IS IT LI LT LU LV MC MT NL NO PL PT RO SE SI SK TR**
Etats d'extension désignés:
**AL BA MK RS**

(30) Priorité: **31.12.2007 FR 0760454**

(71) Demandeur: **Commissariat à l'Energie Atomique
75015 Paris (FR)**

(72) Inventeurs:
• **Gasse, Adrien
38100 Grenoble (FR)**

• **Arques, Marc
38100 Grenoble (FR)**
• **Mathieu, Lydie
38340 Pommiers la Placette (FR)**
• **Brambilla, Andrea
38113 Veurey Voroize (FR)**

(74) Mandataire: **Vuillermoz, Bruno et al
Cabinet Laurent & Charras
"Le Contemporain"
50, Chemin de la Bruyère
69574 Dardilly Cédex (FR)**

(54) **Dispositif de détection de rayonnements électromagnétiques et de rayonnements ionisants à couche de transfert isotrope**

(57) Ce dispositif de détection de rayonnements électromagnétiques, en particulier des rayons X ou des rayons γ, comprend :
- une couche de détection (21) constituée d'au moins un matériau susceptible d'interagir avec lesdits rayonnements électromagnétiques à détecter, de manière à libérer des porteurs de charges mobiles, dont le déplacement génère un courant électrique ;
- un substrat (22) pourvu d'une pluralité de collecteurs élémentaires (23, 29) des porteurs de charges ainsi libérés, lesdits collecteurs élémentaires étant répartis de façon discrète ;
- une couche de transfert (25) destinée à assurer le transfert des porteurs de charges libérés par la couche de détection au niveau des collecteurs élémentaires, ladite couche étant liée à la couche de détection (21) ;
- une couche d'assemblage adhésive isolante (26), destinée à assurer l'assemblage entre la pluralité de collecteurs élémentaires (23, 29) et la couche de transfert (25).

Fig. 3

EP 2 075 845 A1

**Description**

**DOMAINE TECHNIQUE**

La présente invention concerne un dispositif pour la détection de rayonnements électromagnétiques, et de rayonnements ionisants, en particulier des rayons X et/ou des rayons γ. La présente invention se rapporte donc au domaine des détecteurs, qu'il s'agisse de détecteurs matriciels à une ou à deux dimensions ou d'autres formes de détecteurs.

La présente invention se rapporte plus spécifiquement à la structure d'interconnexion électrique et d'assemblage entre les composants d'un tel détecteur.

**ETAT ANTERIEUR DE LA TECHNIQUE**

Dans le domaine des détecteurs destinés à réaliser des images numériques, il existe actuellement dans l'art antérieur deux principes différents pour convertir les rayons électromagnétiques en électrons et, partant, en signaux numériques. Le premier de ces deux principes, dénommé « conversion indirecte », consiste à convertir des rayons X en photons de lumière visible au sein d'un matériau scintillateur, puis à convertir les photons de lumière visible en électrons au moyen de photodiodes réalisées sur des panneaux en matériau semi-conducteur, tel que le silicium amorphe.

Les détecteurs fonctionnant selon ce premier principe présentent cependant de manière connue des performances limitées en termes de résolution et de sensibilité à faible dose d'exposition. De manière connue, la résolution se définit comme étant la capacité d'un détecteur à distinguer deux points - objets dans l'image numérique réalisée. La sensibilité est définie de manière connue, comme la capacité du détecteur à détecter une certaine quantité de photons incidents.

Le deuxième principe de conversion, développé et mis en oeuvre plus récemment, est dénommé « conversion directe ». Les détecteurs fonctionnant selon ce deuxième principe sont appelés à présenter des performances supérieures aux précédentes, en particulier une résolution plus fine et une sensibilité à faible dose plus importante.

Comme il s'agit là de performances fondamentales pour un détecteur, toute amélioration de ces performances est susceptible d'intéresser tous les domaines dans lesquels des détecteurs sont utilisés pour réaliser des images numériques, notamment les domaines de l'imagerie médicale, des instruments scientifiques et spatiaux ou du contrôle non destructif.

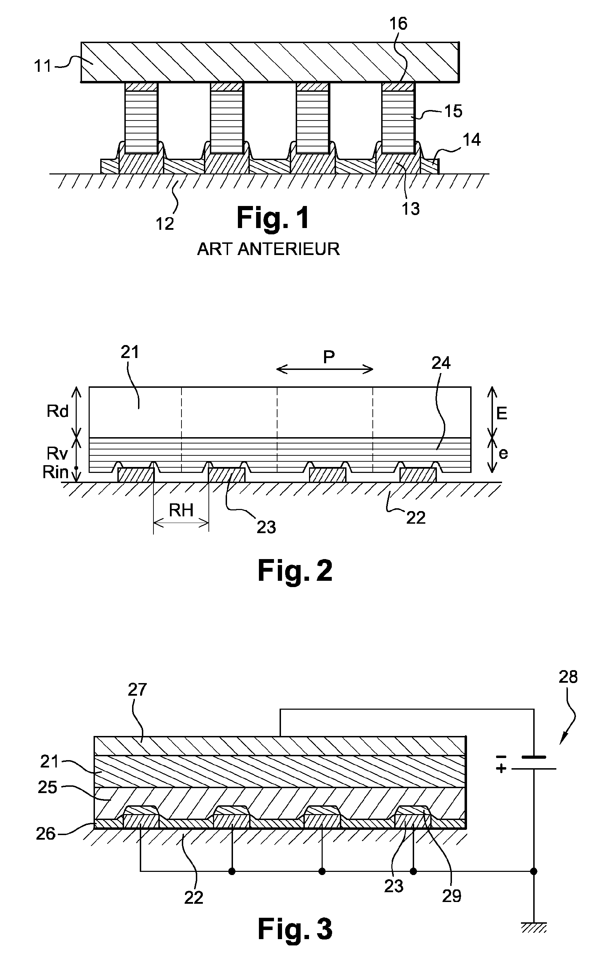

Ce principe de conversion directe est exposé ici en relation avec la figure 1, qui est une représentation schématique en coupe d'un détecteur de l'art antérieur. La conversion directe est réalisée quel que soit le domaine de fréquence des rayonnements électromagnétiques incidents, de type X ou γ.

Le détecteur à conversion directe représenté sur la figure 1 est réalisé et fonctionne au moyen de la technique dite « à puce retournée » (en anglais *flip chip*). Les rayons électromagnétiques incidents sont directement convertis en électrons au sein de la couche de détection **11,** laquelle est généralement réalisée à partir de matériaux à forte densité atomique, comme le CdTe, ou les halogénures de plomb ou de mercure, tels que le $PbI_2$ et le $HgI_2$, etc... Les électrons ainsi générés par les interactions des photons incidents avec la couche de détection **11** forment des courants électriques, dont l'intensité est proportionnelle à l'énergie et au nombre de photons incidents. Ces courants électriques sont collectés et circulent dans des plots conducteurs **15** pour se déplacer jusqu'au circuit de lecture afin d'y être quantifiés donc « numérisés ».

De manière connue, chacun des plots conducteurs **15** correspond à un pixel de la matrice formant l'image numérique. Les plots conducteurs **15** sont par conséquent répartis de manière discrète et régulière dans les deux dimensions du plan du détecteur.

Entre chacun des plots **15** et la couche de détection **11,** se trouve généralement une électrode **16** réalisée en un matériau conducteur tel que l'or, apte à collecter efficacement les porteurs de charges, électrons ou trous, issus des interactions entre photons et matière.

Les plots conducteurs **15** sont chacun montés sur un plot conducteur **13,** par exemple en aluminium, dont le rôle est de transmettre les courants collectés au substrat de lecture **12**. Le substrat de lecture **12** peut comporter un panneau réalisé en silicium amorphe ou polycristallin ou encore un circuit intégré spécifique (d'après l'acronyme anglo-saxon ASIC pour « *Application Specific Integrated Circuit »*), ou du type à semi-conducteur CMOS. Les courants électriques peuvent ensuite être lus et exploités de manière connue en soi par le circuit de lecture pour aboutir à une image numérique représentative de la scène observée.

Par ailleurs, les plots conducteurs **15** sont réalisés en un matériau adhésif présentant une conductivité isotrope. Un tel adhésif est généralement constitué d'une matrice en polymère incluant des charges métalliques réparties de manière uniforme, dont le rôle est d'assurer la conduction électrique.

L'adhésif qui forme le plot **15** a également pour fonction d'assurer la cohésion mécanique entre les plots **13** du circuit de lecture et la couche de détection **11,** généralement munie d'électrodes **16**. Ainsi, le détecteur illustré par la figure 1 est réalisé par l'assemblage et le collage mutuels de deux composants plans au moyen d'une multitude de points de colle répartis selon un réseau régulier correspondant à l'agencement des pixels de la matrice du détecteur.

Au cours de la fabrication du détecteur, les plots conducteurs **15** sont disposés au niveau de chacun des plots **13** du circuit de lecture, puis la couche de détection **11** est rapportée sur les plots conducteurs, l'ensemble subissant ensuite un traitement permettant la prise de la colle des plots adhésifs **15.**

La structure du détecteur illustré par la figure 1 permet donc, outre l'assemblage mécanique évoqué ci-dessus, la transmission intégrale des signaux ou courants électriques depuis la couche de détection **11** vers le circuit de lecture **12-13**. On entend par « *intégrale* » une transmission qui s'effectue sans courant de fuite inter-pixels, c'est-à-dire sans courant de fuite entre plots conducteurs **15** voisins.

En effet, dans une structure continue plane comme celle de la couche de détection **11,** il existe des porteurs de charges qui se dirigent vers les pixels voisins du lieu d'interaction au lieu de se déplacer vers le pixel ou plot conducteur **15** le plus proche. De manière connue en soi, ces courants de fuite inter pixels ou au sein de la couche de détection **11** entraînent une dégradation de la qualité de l'image, c'est-à-dire une diminution du rapport du signal cohérent sur le bruit parasite. Cette dégradation doit, lorsque c'est possible, être compensée par un traitement d'image complexe donc coûteux.

La structure décrite en relation avec la figure 1 présente donc l'avantage d'isoler les plots conducteurs **15** les uns des autres, donc d'empêcher les courants de fuite à leur niveau. Ainsi, les électrons qui parviennent sur les électrodes **16** sont « capturés » par le plot conducteur **15** attenant, ce qui tente à maximiser le rapport signal sur bruit de l'image numérique.

Cependant, l'étape de la fabrication du détecteur consistant à positionner de façon discrète chacun des plots en adhésif conducteur **15** requiert une précision d'autant plus grande que la résolution recherchée est fine.

De plus, il est important de déposer une quantité de matière adhésive identique pour chacun des plots **15** de manière à garantir une connexion électrique effective entre les parties à assembler. Le dosage de cette quantité de matière doit donc être très précis.

Or, la précision requise pour le dosage et le positionnement des plots **15** s'avère souvent difficile à obtenir et obère toujours fortement le prix de revient du détecteur, et ce, quelle que soit la technique utilisée (sérigraphie, dispense...).

En outre, en fonction du matériau adhésif sélectionné pour réaliser les plots **15,** la vitesse de dépôt de l'ensemble des plots **15** peut exercer une influence sur la qualité du collage et, partant, sur la conduction électrique. Cette vitesse représente un paramètre d'autant plus critique que les dimensions de détecteur sont grandes.

Par ailleurs, ce type de connexion ne permet pas une tenue mécanique de l'ensemble suffisante.

Dans le cadre de l'interconnexion électrique de deux composants, on a décrit dans le document US 6,396,712 la mise en oeuvre d'une couche conductrice de résistivité isotrope assurant simultanément les fonctions d'interconnexion et d'assemblage desdits composants. Il est mentionné la possibilité de réparation en utilisant comme couche électriquement conductrice un matériau thermoplastique, dont le faible pouvoir adhésif est bien connu.

La mise en oeuvre des enseignements de ce document se heurte donc à des contraintes importantes pour la pleine maîtrise de l'homogénéité des propriétés de conduction et d'assemblage.

On a décrit dans le document JP-05 167057 un dispositif de détection d'ondes électromagnétiques comportant un détecteur réalisé en CdTe réalisé sur un substrat transparent aux rayonnements à détecter, et pourvu d'électrodes continues sur chacune de ses faces respectivement réalisée en CdS et en a-Si:H, c'est-à-dire en silicium amorphe, et jouant respectivement le rôle de couche d'arrêt des électrons « *electrons stopping layer* », et de couche d'accumulation de charges (« *charge accumulation layer* »). Cette dernière est conductrice électriquement afin de permettre le transfert des charges vers le circuit de lecture via des électrodes et plots de connexion répartis de manière discrète.

Ce type de dispositif présente certaines limites dans la mesure où une pixellisation du détecteur est nécessaire pour permettre la réalisation des contacts sur le silicium amorphe. Or, cette pixellisation constitue une étape fastidieuse et coûteuse, mettant en oeuvre la technologie de la photolithographie, outre des équipements d'alignement complexes d'assemblage. En outre, cet assemblage n'est effectif que par le biais des plots de connexion, ce qui affecte de manière importante la tenue mécanique et la fiabilité de l'ensemble du détecteur. De plus, la réalisation d'électrodes au contact du matériau détecteur entraîne un risque de détérioration locale de ce matériau.

Enfin, on a décrit dans le document JP-2002 334983 un imageur comportant un substrat transparent associé à un conducteur transparent et à un photoconducteur, muni à ses bornes d'une couche dite « *electron hole blocking layer* », c'est-à-dire une couche de blocage des porteurs électriques, et une couche dite « *electronic blocking layers* », c'est-à-dire une couche de blocage des électrons. Il est mentionné en outre une couche de protection résistive réalisée en semi-conducteur amorphe telle que par exemple en a-Se ou en a-Si. Des billes d'hybridation conductrices réalisées en indium, font fonction d'assemblage, et relient l'ensemble ainsi constitué à des électrodes ménagées sur un circuit de lecture. L'ensemble est obtenu par laminage.

Il résulte de cette structure qu'il est nécessaire d'hybrider le circuit de lecture avec un matériau mou, en l'espèce l'indium, afin de réaliser le laminage.

En l'absence de couches d'accrochage sur la couche de protection résistive en semi-conducteur amorphe, il s'avère que la tenue mécanique de l'ensemble est très faible.

En résumé, on ne dispose pas à ce jour d'une technologie d'interconnexion électrique entre une couche de détection et un circuit de lecture s'affranchissant des problèmes de précision et de performance, et permettant de disposer d'un assemblage présentant une tenue mécanique fiable, pérenne, et en outre simple à mettre en oeuvre, et pouvant être facilement réparable selon certains modes de réalisation.

La présente invention a donc pour objet un dispositif pour la détection du rayonnement électromagnétique et ne présentant pas les inconvénients des détecteurs de l'art antérieur.

## EXPOSE DE L'INVENTION

La présente invention permet notamment de résoudre les problèmes techniques exposés précédemment en proposant une configuration de détecteur de rayonnements, notamment de rayonnements X ou $\gamma$, à conversion directe, permettant avec un procédé simple, robuste et performant, la fabrication d'imageurs de grande dimension, typiquement supérieure à 10 x 10 cm, et en outre, ne mettant pas en oeuvre les techniques coûteuses des procédés telle que la photolithographie. Plus spécifiquement, l'invention propose de découpler les fonctions d'interconnexion, c'est-à-dire de collecte de charges générées sous l'action du rayonnement au sein de la couche de photodétection vers le circuit de lecture, et d'assemblage de ladite couche de photodétection au circuit de lecture, permettant ce faisant, d'optimiser les performances de chacune des fonctions respectivement collecte et assemblage.

A cet effet, l'invention propose un dispositif de détection de rayonnements électromagnétiques et de rayonnements ionisants, en particulier des rayons X ou des rayons $\gamma$, comprenant :

- une couche de détection constituée d'au moins un matériau susceptible d'interagir avec lesdits rayonnements électromagnétiques à détecter, de manière à libérer des porteurs de charges mobiles, dont le déplacement génère un courant électrique ;
- un substrat pourvu d'une pluralité de collecteurs élémentaires des porteurs de charges ainsi libérés, lesdits collecteurs élémentaires étant répartis de façon discrète ;
- une couche de transfert adhésive à conduction électrique isotrope, liée à la couche de détection, et destinée à assurer le transfert des porteurs de charges libérés par la couche de détection au niveau des collecteurs élémentaires ;
- une couche d'assemblage adhésive électriquement isolante, destinée à assurer l'assemblage entre la pluralité de collecteurs élémentaires et la couche de transfert.

Selon l'invention, la couche de transfert est constituée d'une couche polymère adhésive électriquement conductrice au contact de la couche de détection, et la couche d'assemblage est constituée d'une couche polymère adhésive isolante, au contact de ladite première couche et du substrat muni de ses collecteurs élémentaires.

En d'autres termes, l'invention consiste à dissocier au moyen de deux polymères adhésifs, l'un résistif, l'autre isolant, les fonctions d'interconnexion et de collage.

Ce faisant, il devient possible d'optimiser l'homogénéité du comportement résistif de la couche d'interconnexion (couche résistive) indépendamment de la fonction de l'assemblage.

Selon l'invention, la couche polymère adhésive conductrice, ou résistive, est continue et présente une résistivité isotrope.

En d'autres termes, le détecteur de l'invention présente une couche de transfert ou d'interconnexion commune à tous les collecteurs élémentaires et dans laquelle les porteurs de charge peuvent se mouvoir sans direction privilégiée.

Selon l'invention, le rendement de transfert de la couche polymère adhésive résistive est supérieur à 50%, et en particulier à 75%, ledit rendement étant défini par l'expression :

$$(R_H + R_V + R_{in}) / [R_H + (R_V + R_{in}).(1+K)]$$

où :

- $R_V$ est la résistance de la couche de transfert mesurée sensiblement perpendiculairement à un collecteur élémentaire ;
- $R_H$ est la résistance de la couche de transfert mesurée selon une direction contenue dans un plan sensiblement parallèle à la couche de détection ; cette résistance peut être qualifiée d'« horizontale », bien que les courants de fuite peuvent emprunter des trajets obliques ;

- $R_{in}$ est la résistance d'entrée, également dénommée « impédance d'entrée » de l'un quelconque des collecteurs élémentaires : c'est la résistance vue par le dispositif qui est connecté ;
- K est un nombre multiple de 4, représentant le nombre de collecteurs élémentaires voisins du collecteur élémentaire considéré.

En d'autres termes, les résistances parcourues par les courants électriques présentent des résistivités et des dimensions limitant les courants de fuite « plans » pour maximiser les courants « utiles » ou « transversaux ».

En pratique, la résistance de la couche de transfert est mesurée sensiblement perpendiculairement à un collecteur élémentaire de la couche de transfert, celle-ci étant négligeable devant la résistance de la couche de détection mesurée sensiblement perpendiculairement au même collecteur élémentaire. De plus, la résistance intrinsèque de chaque collecteur élémentaire est négligeable devant la somme des deux résistances précédentes. En outre, le quotient défini au numérateur par la résistance de la couche de transfert, mesurée selon une direction contenue dans un plan sensiblement parallèle à la couche de détection, et au dénominateur par la somme de la résistance d'entrée de l'un quelconque des collecteurs élémentaires et de la résistance de la couche de transfert mesurée sensiblement perpendiculairement à un collecteur élémentaire, est supérieur à 3 et en particulier à 11 dans le cas où le ne considère que les quatre plus proches voisins (c'est à dire pour K = 4).

Selon l'invention, la couche polymère adhésive résistive est un matériau organique, thermoplastique ou thermodurcissable, composé par exemple de polymères sélectionnés dans le groupe comprenant les époxys, les acrylates, les polyuréthanes et les silicones. Ce matériau comporte des particules conductrices constituées d'un élément sélectionné dans le groupe comprenant par exemple le carbone, l'or, le platine, l'argent, le nickel, l'aluminium et le cuivre.

Avantageusement, ces particules conductrices sont de tailles submicroniques.

Avantageusement, l'adhésif résultant présente une dureté SHORE D inférieure à 100 lorsqu'il est polymérisé.

Alternativement, le matériau constitutif de la couche polymère adhésive résistive peut être ainsi constituée d'un polymère intrinsèquement conducteur, sélectionné dans le groupe comprenant la polyaniline, le polypyrole et le polythiophène, un tel polymère étant intégré dans un adhésif polymère de type époxy ou acrylate.

Selon une autre caractéristique de l'invention, la couche de polymère adhésif électriquement isolante est constituée d'un matériau organique, thermoplastique ou thermodurcissable, choisi dans le groupe comprenant les époxys, les acrylates ou silicones.

Avantageusement, il présente une viscosité inférieure à 100 Pa.s, voire inférieure à 10 Pa.s.

**BREVE DESCRIPTION DES FIGURES**

La manière dont l'invention peut être réalisée et les avantages qui en découlent ressortiront mieux de l'exemple de réalisation qui suit, donné à titre indicatif et non limitatif à l'appui des figures annexées.

La figure 1 est, comme déjà dit, une représentation schématique en section d'un détecteur de l'art antérieur.
La figure 2 est une représentation schématique d'une modélisation d'un détecteur mettant en oeuvre une couche de transfert isotrope résistive.
La figure 3 est une représentation schématique en section simplifiée d'un détecteur conforme à l'invention.
La figure 4 est une vue schématique illustrant le procédé d'assemblage d'un détecteur conforme à l'invention.

**DESCRIPTION DETAILLEE DE L'INVENTION**

On a représenté en relation avec la figure 3 un dispositif pour la détection de rayonnements électromagnétiques et de rayonnements ionisants conforme à l'invention. En l'espèce, ce dispositif est plus particulièrement destiné à la détection de rayons X ou de rayons γ, mais la présente invention peut également à s'appliquer à la détection de rayonnements électromagnétiques présentant des spectres d'énergie différents ou de particules chargées.

Selon l'invention, le détecteur comprend une couche de détection **21** également appelée photo-détecteur, constituée d'un ou de plusieurs matériaux susceptibles d'interagir avec les rayons incidents, de façon à libérer des porteurs de charge mobiles. Ces porteurs de charge mobiles peuvent être des électrons ou des trous, et donc porter des charges négatives ou positives.

De manière connue, le déplacement de ces porteurs de charge mobiles, sous l'action d'une tension de polarisation **28** génère des courants électriques, dont l'intensité est représentative de l'énergie déposée par les rayons incidents et, partant, de la scène observée.

Après cette étape de conversion directe dans la couche de détection **21,** les porteurs de charges ou courants doivent être collectés localement au droit de la zone d'impact du rayon incident, de manière à reconstituer une image en deux dimensions. A cet effet, le détecteur de l'invention comporte un substrat **22** présentant une pluralité de collecteurs élémentaires **23** répartis de façon discrète, de manière à former un réseau ou une matrice. Les collecteurs élémentaires

23 servent à collecter ou à drainer les porteurs de charges libérés par les interactions entre photons et matière.

Dans l'exemple décrit, les collecteurs élémentaires **23** sont constitués par des plots protubérants. Ces plots ou collecteurs élémentaires **23** sont mutuellement indépendants, c'est-à-dire qu'ils sont électriquement isolés les uns des autres, de manière à ne collecter chacun que des porteurs de charges produits au niveau de leur pixel. Par définition, un pixel représente une surface élémentaire de l'image et, par extension, du détecteur. Cette surface élémentaire est le plus souvent constituée par un carré. Chacun des collecteurs élémentaires **23** est donc entouré d'un isolant électrique sur ses côtés, et son socle constitue le substrat de lecture **22**.

Entre la couche de détection **21** et les collecteurs élémentaires **23,** le détecteur présente, conformément à l'invention :

■ une couche de transfert **25,** ainsi dénommée en raison de la fonction qui lui est dévolue, et qui consiste à permettre le transfert des porteurs de charges libérés par les interactions entre photons et matière, depuis la couche de détection **21** vers les différents collecteurs élémentaires **23 ;**
■ et une couche d'assemblage **26,** assurant l'assemblage entre les collecteurs **23** et la couche de transfert **25.**

Selon l'invention, la couche d'interconnexion **25** s'étend de manière continue entre la couche de détection **21** et les collecteurs élémentaires **23**. De fait, elle assure un contact électrique entre la couche de détection **21** et les collecteurs élémentaires **23** du substrat de lecture.

Cette caractéristique structurelle de la couche d'interconnexion **25** permet d'ores et déjà de s'affranchir des inconvénients des détecteurs de l'art antérieur. En effet, il n'est plus nécessaire d'opérer avec une précision de positionnement ni de dosage importante, puisque ladite couche est désormais appliquée de manière continue sur l'ensemble de la surface du détecteur, et en l'espèce, sur l'ensemble de la surface de la couche de détection **21**. Cette couche peut, par exemple, se présenter sous la forme d'un film polymère adhésif de résistivité contrôlée et isotrope.

En d'autres termes, la résistivité de la couche d'interconnexion **25** est identique quelle que soit la direction du courant qui la traverse. Cette caractéristique permet de garantir une circulation correcte des courants depuis la couche de détection **21** en direction des collecteurs élémentaires **23,** et ainsi d'assurer un bon fonctionnement général du détecteur.

Cette conductivité isotrope garantit donc des durées de longueur de parcours des porteurs de charges dans ladite couche d'interconnexion **25** sensiblement similaires d'un pixel à l'autre, garantissant ainsi la qualité de l'image numérique finale.

La résistivité de cette couche continue d'interconnexion **25** doit être en outre suffisamment faible pour assurer le transfert des charges verticalement en direction des plots d'interconnexion, et cependant suffisamment forte pour assurer l'isolation entre pixels voisins.

Autrement dit, l'électrode (et par exemple l'anode dans le cas de porteurs de charge négative) constituée par cette couche continue d'interconnexion est réalisée en un matériau présentant un comportement conducteur fortement résistif pour tout à la fois permettre le transfert des charges en vertical, dans l'exemple décrit, depuis la couche de détection **21** vers les collecteurs élémentaires **23** du substrat de traitement du signal, et tout à la fois assurer une certaine isolation électrique entre chaque pixel fictif de la couche de détection **21** pour permettre la réalisation d'un détecteur image fonctionnellement pixellisée à partir d'un photodétecteur non physiquement pixellisé.

Par ailleurs, et conformément à une autre caractéristique de l'invention, le rendement de transfert de la couche d'interconnexion **25** est supérieur à 50 % et même à 75 %. Le rendement de transfert correspond au rapport de la quantité de porteurs de charges effectivement transférée depuis la couche de détection **21** vers un collecteur élémentaire **23** et la quantité de porteurs de charges qui se dispersent sous forme de courants de fuite se dirigeant vers les collecteurs élémentaires voisins. Ce rendement de transfert peut être défini par l'équation : $(R_H + R_V + R_{in}) / [R_H + (R_V + R_{in}).(1+K)]$, où :

- $R_V$ est la résistance de la couche d'interconnexion **25** mesurée sensiblement perpendiculairement à un collecteur élémentaire **23,**
- $R_H$ est la résistance « horizontale » de la couche d'interconnexion **25** mesurée selon une direction contenue dans un plan sensiblement parallèle à la couche de détection **21,**
- $R_{in}$ est la résistance intrinsèque de l'un quelconque des collecteurs élémentaires **23,**
- K est un nombre multiple de 4, représentant le nombre de collecteurs élémentaires **23** voisins du collecteur élémentaire considéré.

Ainsi, lorsque la couche d'interconnexion **25** conforme à l'invention présente un rendement de transfert supérieur à 50 % et même à 75 %, le détecteur présente un rapport signal sur bruit satisfaisant pour réaliser des images numériques. Bien entendu, en fonction des applications et donc de la qualité d'image recherchée, il est possible de sélectionner une couche de transfert présentant un rendement de transfert plus ou moins important.

Pour atteindre un tel rendement de transfert, le détecteur illustré par la figure 2 présente les caractéristiques suivantes, conformément à une modélisation du principe de l'invention.

Tout d'abord, la résistance de la couche d'interconnexion **25** mesurée sensiblement perpendiculairement à un collecteur élémentaire **23** est négligeable devant la résistance de la couche de détection **21** mesurée sensiblement perpendiculairement au même collecteur élémentaire **23**. On entend par négligeable un rapport entre ces deux résistances supérieur à 10, voire à 100.

Cette caractéristique implique que la tension de polarisation **28** appliquée au détecteur se compose d'une différence de potentiel importante dans la couche de détection **21**. On génère ainsi un champ électrique présentant une intensité suffisante pour déplacer les porteurs de charges libérés lors des interactions entre photons et matière jusque vers les collecteurs élémentaires **23** composant le circuit de lecture.

De plus, la résistance intrinsèque de chaque collecteur élémentaire **23** est négligeable devant la somme de la résistance verticale de la couche d'interconnexion **25** et de la résistance verticale de la couche de détection **21**. Cette caractéristique permet au collecteur élémentaire **23** composant le circuit de lecture de collecter effectivement les porteurs de charges provenant de la couche de détection **21**. En effet, les porteurs de charges mobiles peuvent ainsi pénétrer facilement dans le plot ou collecteur élémentaire **23**.

En outre, le détecteur modélisé sur la figure 2 se caractérise en ce que le quotient défini au numérateur par la résistance de la couche d'interconnexion **25,** mesurée selon une direction contenue dans un plan sensiblement parallèle à la couche de détection **21,** et au dénominateur par la somme de la résistance intrinsèque de l'un quelconque des collecteurs élémentaires **23** et de la résistance de la couche d'interconnexion **25** mesuré sensiblement perpendiculairement à un collecteur élémentaire **23** est supérieur à 3 et en particulier à 7.

Cette caractéristique contribue à assurer un rendement de transfert supérieur à 50 %, c'est-à-dire à collecter davantage de porteurs de charges ou de courants au niveau d'un collecteur élémentaire **23** par rapport aux porteurs de charges générés au droit de ce collecteur élémentaire **23** considéré, et collectés par les collecteurs élémentaires voisins, autrement dit par rapport aux courants de fuite.

En d'autres termes, si l'on considère un détecteur plan horizontal, il s'agit du rapport entre le courant collecté verticalement au niveau d'un collecteur élémentaire et les courants de fuite, sensiblement obliques, voire horizontaux.

Dans le cas théorique où ce rapport vaut 100 %, le rapport signal sur bruit est maximal, ce qui conduit à une qualité d'image quasiment parfaite. A l'inverse, lorsque ce rapport est petit, par exemple inférieur à 50 %, on parle d'effet « d'épanouissement spatial » pour décrire l'importance des courants de fuite, qui entraînent une importante dégradation de la résolution de l'image.

On considère néanmoins qu'il n'est théoriquement pas possible d'obtenir un rendement de transfert, ou un tel rapport valant 100 %, même dans le cas des détecteurs de l'art antérieur où les pixels sont parfaitement isolés électriquement les uns des autres, car l'épanouissement des porteurs de charges peut également se produire dans la couche de détection malgré sa forte résistivité.

Ainsi, la résistivité de la couche d'interconnexion **25** est donc choisie de manière à réaliser ces résistances caractéristiques de l'invention. En d'autres termes, la résistivité de la couche de transfert doit être suffisamment faible pour permettre la collecte « verticale » au sens de la figure 2 des porteurs de charges libérés et suffisamment forte pour que ces porteurs de charges ne « s'épanouissent pas » selon des directions horizontales vers les plots voisins du lieu d'interaction entre photons et matière. Le comportement électrique d'une telle couche de transfert est tout à fait particulier, et doit donc présenter une résistivité intermédiaire comprise entre celle d'un matériau conducteur et celle d'un matériau semi-conducteur, et notamment plus proche de celle d'un matériau semi-conducteur.

Comme indiqué précédemment, le rendement de transfert s'exprime par l'équation : $(R_H+R_V+R_{in})$ / $[R_H+(R_V+R_{in}).(1+K)]$

En effet, le nombre de collecteurs élémentaires voisins peut aller de trois, lorsque le collecteur élémentaire considéré occupe l'un des coins de la matrice, jusqu'à huit, lorsque le collecteur élémentaire considéré se trouve à un endroit quelconque au sein de la matrice. Dans ce dernier cas, il y a lieu d'opérer une distinction entre les collecteurs élémentaires voisins, car ils ne sont pas tous situés à la même distance du collecteur élémentaire considéré. Ainsi, parmi les huit voisins disposés en carré autour d'un plot, les quatre plots occupant les coins de ce carré sont les plus éloignés du plot central, tandis que les quatre autres en sont les plus proches.

Il existe un cas particulier dans lequel la résistance intrinsèque $R_{in}$ est négligeable devant les résistances $R_H$ et $R_V$. Dans ce cas, l'équation définissant le rendement de transfert peut être simplifiée et elle dépend alors seulement des résistances $R_H$ et $R_V$. Cette équation simplifiée s'écrit : $(R_H+R_V)$ / $[R_H+(R_V).(1+K)]$

Typiquement, la résistivité de la couche d'interconnexion 25 se situe entre $10^5$ et $10^8$ Ω.cm, la couche de détection **21** présentant une résistivité typiquement comprise entre $10^8$ et $10^{12}$ Ω/cm.

Selon une autre caractéristique essentielle de l'invention, le détecteur comporte également une couche d'assemblage **26,** destinée à réaliser l'assemblage et donc le maintien de l'ensemble constitué par la couche de détection **21** et la couche d'interconnexion **25** au substrat **22** muni des collecteurs élémentaires **23**.

Cette couche d'assemblage **26** est donc limitativement dédiée à cette seule fonction d'assemblage. Elle est électriquement isolante pour ne pas perturber la collecte des charges par les collecteurs élémentaires **23**.

Corollairement, la couche d'interconnexion **25** est liée à la couche de détection **21.** Elle assure l'interconnexion électrique entre la couche de détection **21** et les collecteurs élémentaires **23.**

Par ce biais, on découple physiquement les fonctions d'interconnexion et d'assemblage.

Comme pour la couche d'interconnexion **25,** on met en oeuvre pour la couche d'assemblage **26** un film adhésif polymère mais cette fois isolant électrique.

Plus particulièrement, et avantageusement, l'adhésif mis en oeuvre pour constituer la couche d'interconnexion isotrope n'est polymérisée que partiellement ou complètement, avant l'étape d'assemblage proprement dite, permettant ainsi la mise en oeuvre d'une plus large gamme d'adhésifs dans la mesure où, en fonction de sa seule fonction d'interconnexion, il n'existe plus de contraintes liées à l'assemblage.

Ce faisant, on peut utiliser un adhésif à température de polymérisation plus élevée, mais également un adhésif contenant un solvant.

En outre, on peut obtenir une très bonne homogénéité de comportement électrique de l'adhésif constitutif de cette couche d'interconnexion, une fois réticulée.

Au surplus, il devient possible d'ajuster l'épaisseur de la couche d'interconnexion **25** uniquement au regard de la résistance interpixel souhaitée et indépendamment de la planéité des composants à assembler.

L'ensemble constitué par la couche de détection **21** et la couche d'interconnexion **25** est assemblé au circuit de lecture constitué par le substrat **22** et les collecteurs élémentaires **23** par un processus de thermo-compression au moyen de l'adhésif isolant **26** assurant l'assemblage mécanique.

Afin de permettre un contact électrique entre les collecteurs élémentaires **23** du circuit de lecture **22** et la couche d'interconnexion **25,** des protubérances **29** sont réalisées sur les collecteurs élémentaires **23.**

Ce faisant, en raison de cette thermocompression, l'interconnexion entre la couche d'interconnexion **25** et les protubérances **29** des collecteurs élémentaires **23** est obtenue par contact direct.

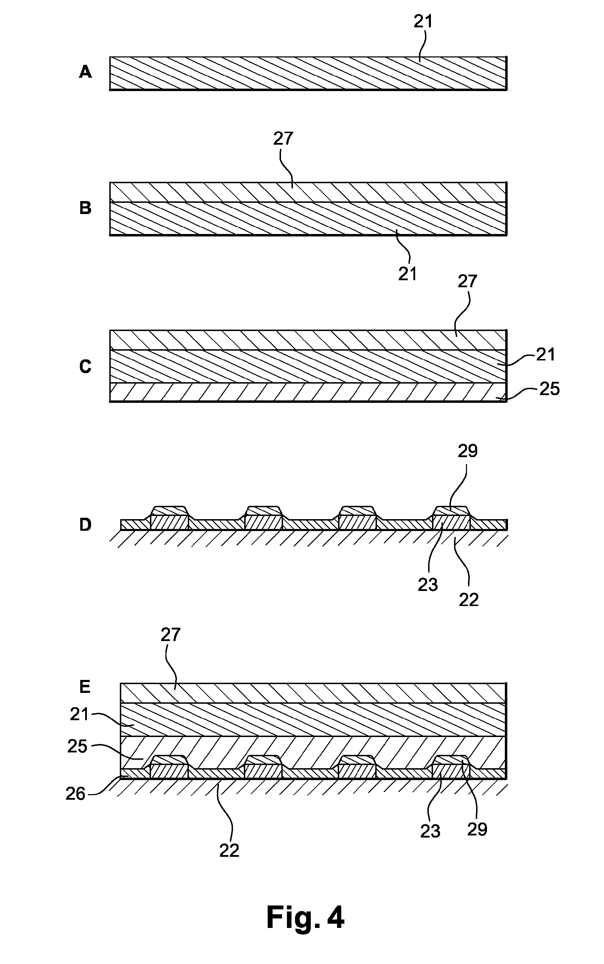

Il va être décrit en relation avec la figure 4, un procédé de réalisation du détecteur de rayonnements électromagnétiques conforme à l'invention.

On procède tout d'abord à la préparation de l'adhésif constitutif de la couche d'interconnexion **25.** L'objectif visé dans l'exemple numérique précité est d'obtenir une résistivité pour cette couche comprise entre $10^5$ et $10^8$ Ω.cm.

A cet effet, on met en oeuvre un adhésif, tel que commercialisé sous la référence E320 par la société EPOTEK. Cet adhésif isotropique est constitué de particules submicroniques intégrées dans une matrice adhésive de type époxy. Ce matériau bicomposant comporte une base et un durcisseur avec une proportion de particules de carbone submicroniques de l'ordre de 20% en masse.

On mélange cet adhésif avec un autre adhésif époxy, compatible chimiquement, parfaitement diélectrique, et tel que commercialisés par la société EPOTEK sous la référence E301. La proportion relative du mélange de ces deux adhésifs est choisie pour obtenir la résistivité souhaitée comprise dans la fourchette précitée.

On observe qu'il est souhaitable que la proportion en masse de l'adhésif diélectrique E301 ne dépasse pas 50%, afin de maximiser l'isolation interpixel.

La couche de détection **21** est constituée, comme déjà dit, d'un matériau apte à détecter un rayonnement, et en l'espèce des rayons X ou γ. Ces matériaux sont aujourd'hui bien connus et sont constitués de semi-conduteurs de forte résistivité appartenant aux familles II-VI ou III-V, généralement de numéro atomique élevé. Les plus connus et les plus usuels sont notamment le CdTe, le CdTe dopé au clore, le CdZnTe, le HgCdTe, le silicium, l'arséniure de gallium (AsGa), l'oxyde de plomb (PbO), l'iodure de plomb ($PbI_2$), l'iodure de mercure ($HgI_2$), le sélénium, etc.

Ce photoconducteur **21** peut être de type autosupporté et fabriqué selon les techniques classiques de réalisation des semi-conducteurs.

Il peut cependant être également déposé en couche épaisse sur un substrat transparent aux rayonnements à détecter, tel que du graphite, de l'aluminium et plus généralement tout élément conducteur et de faible poids atomique, chimiquement compatible avec le photoconducteur. Par exemple, on peut mettre en oeuvre une couche photoconductrice à base de CdTe obtenue par la technique de croissance dite CSS (selon l'acronyme anglo-saxon « *Close Space Sublimation* ») sur un substrat de graphite.

Pour des applications visant la détection de rayonnement X ou γ, l'épaisseur de la couche de détection **21** est typiquement comprise entre 50 micromètres et un centimètre. Cette épaisseur peut être augmentée ou diminuée pour d'autres applications. Sa résistivité est généralement comprise entre $10^8$ et $10^{12}$ Ω.cm.

Lorsque ledit photodétecteur **21** est autosupporté, on procède au dépôt d'une électrode commune **27,** notamment par toute technique de dépôt de couche mince métallique, et notamment par évaporation, pulvérisation, voire même par croissance sans courant, mieux connue dans la littérature sous l'expression anglo-saxonne « *electroless* ».

On procède alors à l'étape de dépôt de l'adhésif constitutif de la couche d'interconnexion **25** (figure 4C).

L'adhésif préparé tel que précédemment décrit et non polymérisé est étalé sur le photoconducteur **21** sous forme de film. Toute technique de sérigraphie peut être utilisée pour le dépôt dudit adhésif, notamment enduction, « spin coating » (étalement à la tournette), ou plus généralement toute technique adaptée à la mise en forme de film mince de liquides visqueux.

L'épaisseur de ce film est typiquement comprise entre 1 et 20 μm Une épaisseur très fine permet en effet de limiter les fuites interpixel, alors même qu'une couche plus épaisse permet d'être plus tolérant par rapport à la planéité du photodétecteur et/ou à l'homogénéité en épaisseur des protubérances **29** des plots ou collecteurs élémentaires **23** du circuit de lecture.

Une fois déposée sous forme de film, la couche polymère est polymérisée par un cycle thermique partiellement ou complètement. Cependant, afin d'obtenir un contact intime ultérieurement avec les protubérances **29** des collecteurs élémentaires **23** du circuit de lecture, il est important que cette couche conserve une certaine souplesse, d'où l'intérêt d'une réticulation ou polymérisation partielle de ladite couche, la réticulation totale étant obtenue pendant ou après la phase d'assemblage, décrite ci-après.

On procède ensuite à la préparation du circuit de lecture (figure 4D).

Le circuit de lecture est un substrat muni de plots conducteurs **23**. Ces plots conducteurs ou collecteurs élémentaires **23** permettent, ainsi que déjà dit, de collecter les charges photo-créées dans le photodétecteur **21** via la couche d'interconnexion **25**. Dans sa forme la plus simple, ces plots sont reliés individuellement à des plots de test ou de sortie (substrat appelé réseau d'interconnexion). Dans une forme plus évoluée, le substrat comprend des composants électroniques de traitement du signal : ce peut être un ASIC, un circuit CMOS, un panneau à base de TFT (« *Thin Film Transistor* »), un panneau CCD (« *Charge Coupled Device* »), etc. Traditionnellement, les plots d'interconnexion **23** du circuit de lecture sont en finition aluminium ou cuivre pour des raisons évidentes de conduction.

Pour la réalisation des protubérances **29,** on choisit de préférence comme finition un métal non oxydable présentant un caractère métallique conducteur de quelques dixièmes de micromètres. Ce métal peut être de l'or, du platine, du palladium ou de l'argent. Entre la finition du circuit de lecture et celle de la protubérance, il est en outre possible d'utiliser un autre métal que celui de la finition qui est généralement plus épais (en général inférieur à 10 micromètres) et tel que par exemple du nickel, cuivre, titane, zirconium, tantale, tungstène, molybdène, vanadium, chrome, voire un ou plusieurs alliages ou nitrures de ces éléments.

Le circuit de lecture est en général muni d'une passivation minérale séparant les plots métalliques. Les plots peuvent être réalisés par électrolyse sans courant permettant ainsi de réaliser des plots Ni/Au de quelques micromètres d'épaisseur, typiquement à 1 à 10 micromètres.

L'assemblage proprement dit est alors réalisé (figure 4E).

Deux variantes sont envisageables pour l'assemblage de l'ensemble constitué par le photodétecteur **21** et la couche d'interconnexion **25,** et le circuit de lecture **22, 23**.

Dans une première variante, on place en regard le photoconducteur **21** muni de la couche isotrope résistive d'interconnexion **25** partiellement polymérisée (exemple pendant 1 heure à 50 °C) en regard du substrat de lecture muni de ses plots ou collecteurs élémentaires **23,** et par exemple constitué d'un circuit d'imagerie CMOS, présentant une matrice de plots au pas de 75 microns. Il convient de souligner que l'alignement du photodétecteur **21** muni de la couche d'interconnexion **25** par rapport au substrat **22** du circuit de lecture est relativement grossier, dans la mesure où il n'y a pas d'électrode sur le photoconducteur **25**.

Un cycle de thermocompression est appliqué avec une faible pression, typiquement inférieures à $10^{-1}$ MPa à 50°C pendant 1 heure. Ce cycle permet d'aboutir à une réticulation complète de la couche résistive isotrope d'interconnexion **25,** et assure une tenue mécanique modérée de l'assemblage, puisque les seuls points d'assemblage se trouvent au niveau des protubérances **29**. Afin d'obtenir une résistance mécanique renforcée, une infiltration de colle est réalisée par capillarité depuis l'un des côtés de l'assemblage pour remplir l'espace entre la couche isotrope polymère **25** et le circuit de lecture. Puis, cette colle ainsi intégrée est polymérisée.

Dans une telle configuration, on peut utiliser avantageusement une colle très fluide, telle que celle déjà citée de la société EPOTEK sous la référence E301, qui polymérise également à basse température, et ce, par exemple pendant 2 heures à 50°C.

Ce procédé d'assemblage s'avère adapté dans le cas de l'assemblage de détecteurs de petites surfaces (quelques millimètres carrés).

Dans le cas de grandes surfaces d'assemblage, le contrôle de la capillarité est complexe et favorable à la formation de bulles, d'où la mise en oeuvre d'une autre technique décrite ci-après.

Dans cette seconde configuration, on enduit le circuit de lecture d'un film fin de colle isolante du type celle précédemment décrite (E320 - EPOTEK). L'épaisseur de film, et donc la quantité de colle, est calculée en fonction de la hauteur des protubérances **23,** de façon à remplir complètement mais sans excès l'espace entre le circuit de lecture et la couche résistive isotrope d'interconnexion **25**. On place alors en regard le photoconducteur **21** muni de la couche isotrope résistive **25** complètement polymérisée, par exemple soumis pendant 2 heures à une température de 50°C, et le substrat de lecture enduit de la colle isolante **26**. Là encore il convient de souligner que l'alignement de l'un par rapport à l'autre est relativement grossier, dans la mesure où le photoconducteur est dépourvu d'électrodes.

Un cycle de thermo-compression est appliqué avec une faible pression, typiquement inférieures à $10^{-1}$ MPa à 50°C pendant 2 heures, afin d'aboutir à une réticulation complète de la couche isolante **26** assurant l'assemblage mécanique.

La colle isolante **26,** éventuellement située en dessus des protubérances **29** est chassée de ce lieu lors du processus de thermo-compression, assurant ainsi le contact électrique entre lesdites protubérances **29** et la couche de transfert ou d'interconnexion **25.**

Il convient de noter que lors de la phase de thermo-compression, les protubérances **29** des collecteurs élémentaires **23** chassent les rares bulles en dehors des zones de contact avec la couche résistive isotrope d'interconnexion **25,** assurant ainsi un bon contact électrique. Ce procédé n'engendre que la formation d'un nombre limité de bulles dans l'assemblage, qui au surplus ne nuisent pas à la qualité de l'assemblage mécanique.

Afin d'optimiser cette variante d'assemblage, il est également possible de réaliser une thermocompression sous vide modéré, permettant de diminuer encore plus l'apparition de bulles au sein de l'assemblage.

Le procédé et le détecteur conformes à l'invention présentent un certain nombre d'avantages développés ci-après.

Tout d'abord, il convient de souligner le découplage entre la fonction d'interconnexion et la fonction d'assemblage proprement dites. Ce faisant, il devient possible d'optimiser l'homogénéité du comportement résistif de la couche d'interconnexion **25** indépendamment de la fonction d'assemblage, notamment par la disparition ou la réduction drastique des bulles susceptibles de rester piégées au niveau des interfaces, et qui conduit dans le cas de l'utilisation d'un adhésif conducteur à des défauts d'interconnexion. Dans le cadre du procédé de l'invention, la couche isotrope conductrice d'interconnexion **25** est à tout le moins partiellement polymérisée avant l'assemblage, ce qui garantit l'absence de telles bulles au contact du photodétecteur **21.** Lors de la phase de thermo-compression, les éventuelles bulles sont repoussées en dehors des protubérances **29,** entre les plots **23** du circuit de lecture, ce qui n'affecte pas l'interconnexion électrique entre la couche d'interconnexion **25** et le circuit de lecture, et ne réduit pas davantage l'adhérence mécanique de façon significative.

Il peut être envisagé de mettre en oeuvre comme couche d'assemblage (isolante) un matériau réparable. Dans ce cas, on peut notamment mettre en oeuvre un silicone, qui perd ses propriétés adhésives dans un solvant adapté, qui peut par exemple être constitué par du trichloréthylène ($CHCl_3$).

Dans le détecteur de l'invention, il n'y a pas de pixellisation de l'anode, et les lignes de champ électrique résultant de la polarisation **28** du détecteur couvrent entièrement ledit détecteur, éliminant de la sorte les zones « mortes » du photoconducteur et permettant ainsi de maximiser le rendement des charges photo-créées, et par voie de conséquence, le rapport signal sur bruit et ce, contrairement aux détecteurs de l'art antérieur, dans lequel les charges générées dans le photoconducteur sont collectées par les anodes suivant des lignes de champ électrique induisent la formation de zones « mortes », provoquant des phénomènes de traînage et un effet fantôme.

En d'autres termes, dans le détecteur de l'invention, il n'y pas de pixellisation dudit détecteur, la pixellisation de l'image étant imposée non par le détecteur, mais par la géométrie des électrodes du substrat de traitement du signal (circuit de lecture).

Dans le cadre dudit détecteur de l'invention, la collecte des charges est effectuée directement au moyen d'une couche de résistivité isotrope (couche d'interconnexion **25).** Contrairement à l'art antérieur, dans lequel des électrodes sont réalisées directement sur le photodétecteur ou sur une couche intermédiaire semiconductrice, nécessitant la mise en oeuvre de procédés de photolithographie coûteux et susceptibles de nuire à la performance du photodétecteur.

Au surplus, cette couche résistive **25** n'est pas constituée d'un film mince de silicium amorphe ou d'autres matériaux, mais simplement constituée d'un matériau polymère adhésif, pouvant être obtenu par une technique simple et peu coûteuse, telles que notamment la sérigraphie, et toutes les techniques d'enduction, ou plus généralement toute technique adaptée à la mise en forme de film mince de liquide visqueux.

En outre, la mise en oeuvre d'un matériau polymère adhésif comme couche de résistivité d'interconnexion permet d'utiliser des adhésifs qui polymérisent à basses températures, typiquement inférieures à 100 °C, voire inférieures à 50°C, ce qui limite les risques d'endommagement des propriétés électroniques du photoconducteur, de conserver une certaine souplesse à la couche ainsi réalisée même après polymérisation, permettant d'obtenir et de garantir par thermocompression ultérieure sur les protubérances **29** du circuit de lecture un bon contact électrique sans appliquer une trop forte pression, puisqu'il est mis en oeuvre un contact matériau dur (plot du circuit de lecture) / matériau souple (couche d'adhésif polymère).

Au surplus, en raison de la mise en oeuvre un tel matériau polymère adhésif, il est possible de tester les performances du détecteur sur un substrat de test uniquement par mise en pression légère, avant son assemblage par collage sur le circuit de lecture définitif.

En outre, l'utilisation d'une couche polymère souple et compressible permet d'accommoder tous les défauts de planéité inhérents la fabrication du détecteur et/ou de circuit de lecture.

On peut également souligner qu'il est possible d'utiliser pour les charges incluses dans l'adhésif isotrope constitutif de la couche d'interconnexion **25** du carbone ou d'autres matériaux conducteurs, tels que les polymères conducteurs intrinsèques, qui sont stables et compatibles chimiquement avec le photoconducteur **21.** Ceci permet d'éviter l'utilisation de matériaux métalliques d'électrodes qui réagissent avec le détecteur par diffusion.

La mise en oeuvre pour l'assemblage proprement dit d'un adhésif isolant permet de sélectionner celui-ci de telle sorte qu'il présente une faible température de polymérisation, typiquement inférieure à 100 °C, voire même inférieure à 50°C, s'avérant tout particulièrement avantageux pour l'assemblage de composants de grandes dimensions (plusieurs centaines de centimètres carrés). En effet, les photoconducteurs **21** et le silicium constitutif du circuit de lecture n'ont pas les mêmes coefficients de dilatation thermique, ce qui pourrait induire des contraintes thermomécaniques, voire un endommagement lors d'un assemblage en température. En outre, la polymérisation à basse température permet de limiter les risques d'endommagement de la couche de détection.

De plus, avec l'invention, le matériau d'interconnexion (couche **25)** est déposé en pleine couche, contrairement aux techniques de l'art antérieur, dans lesquelles il est nécessaire de structurer le matériau d'interconnexion de façon discrète, soit par des techniques soustractives de photolithographie, soit par des techniques additives de sérigraphie ou jets d'encre, qui nécessitent toutes le contrôle de la quantité de matière pour chaque plot d'interconnexion, contrôle devenant particulièrement critique quand le pas des pixels devient typiquement inférieur à 100 micromètres et quasiment irréalisable pour des pas inférieurs à 50 micromètres.

Il résulte de ce qui précède que l'invention s'avère particulièrement simple à mettre en oeuvre pour la réalisation de systèmes de détection de rayonnements électromagnétiques, notamment pour des pas réduits (inférieurs à 100 micromètres) mais également applicables pour des pas de plus grandes dimensions.

En outre du fait que le matériau d'interconnexion (couche **25)** est déposé en pleine couche, un même photo-détecteur peut être assemblé indifféremment à différents circuits de lecture présentant une taille de matrice ou un pas de pixel différent, sans avoir à réaliser de préparations spécifiques du détecteur.

L'invention décrite ci-dessus peut aussi bien s'appliquer à la collecte de charges créées par l'interaction d'un rayonnement ionisant dans un matériau détecteur semi-conducteur, que ces charges soient positives ou négatives. Bien que les figures et exemples décrits représentent une collecte de charges négatives, on comprend que l'invention s'applique également à la collecte de charges positives.

## Revendications

1. Dispositif de détection de rayonnements électromagnétiques et de rayonnements ionisants, en particulier des rayons X ou des rayons γ, comprenant :

   - une couche de détection (21) constituée d'au moins un matériau susceptible d'interagir avec lesdits rayonnements électromagnétiques à détecter, de manière à libérer des porteurs de charges mobiles, dont le déplacement génère un courant électrique ;
   - un substrat (22) pourvu d'une pluralité de collecteurs élémentaires (23, 29) des porteurs de charges ainsi libérés, lesdits collecteurs élémentaires étant répartis de façon discrète ;
   - une couche de transfert (25) constituée d'une couche polymère électriquement conductrice, apte à assurer le transfert des porteurs de charges libérés par la couche de détection au niveau des collecteurs élémentaires, ladite couche étant liée à la couche de détection (21) ;
   - une couche d'assemblage adhésive isolante (26), destinée à assurer l'assemblage entre la pluralité de collecteurs élémentaires (23, 29) et la couche de transfert (25).

2. Dispositif de détection de rayonnements électromagnétiques et de rayonnements ionisants selon la revendication 1, *caractérisé* **en ce que** la couche de transfert est adhésive, et **en ce que** la couche d'assemblage (26) est constituée d'une couche polymère adhésive isolante.

3. Dispositif de détection de rayonnements électromagnétiques et de rayonnements selon l'une des revendications 1 et 2, *caractérisé* **en ce que** la couche de transfert (25) est continue et présente une résistivité isotrope.

4. Dispositif de détection de rayonnements électromagnétiques et de rayonnements ionisants selon l'une des revendications 1 à 3, *caractérisé* **en ce que** le rendement de transfert de la couche de transfert (25) est supérieur à 50%, et en particulier à 75%, ledit rendement étant défini par l'expression :

$$(R_H + R_V + R_{in}) \, / \, [R_H + (R_V + R_{in}).(1+K)]$$

où :

   - $R_V$ est la résistance de la couche de transfert (25) mesurée sensiblement perpendiculairement à un collecteur élémentaire (23) ;

- $R_H$ est la résistance de la couche de transfert (25) mesurée selon une direction contenue dans un plan sensiblement parallèle à la couche de détection (21) ;

- $R_{in}$ est la résistance d'entrée, également dénommée « impédance d'entrée » de l'un quelconque des collecteurs élémentaires (23) ;

- K est un nombre multiple de 4, représentant le nombre de collecteurs élémentaires voisins du collecteur élémentaire considéré.

5. Dispositif de détection de rayonnements électromagnétiques et de rayonnements ionisants selon l'une des revendications 1 à 4, *caractérisé* **en ce que** la couche de transfert (25) est constituée d'un matériau organique, thermoplastique ou thermodurcissable.

6. Dispositif de détection de rayonnements électromagnétiques et de rayonnements ionisants selon la revendication 5, *caractérisé* **en ce que** le matériau organique est composé de polymères sélectionnés dans le groupe comprenant les époxys, les acrylates, les polyuréthanes et les silicones, intégrant des particules conductrices.

7. Dispositif de détection de rayonnements électromagnétiques et de rayonnements ionisants selon la revendication 6, *caractérisé* **en ce que** les particules conductrices sont de taille submicronique, et sont choisies dans le groupe comprenant le carbone, l'or, le platine, l'argent, le nickel, l'aluminium et le cuivre.

8. Dispositif de détection de rayonnements électromagnétiques et de rayonnements selon l'une des revendications 5 à 7, *caractérisé* **en ce que** l'adhésif constitutif de la couche de transfert (25) présente une dureté SHORE D inférieure à 100 lorsqu'il est polymérisé.

9. Dispositif de détection de rayonnements électromagnétiques et de rayonnements ionisants selon l'une des revendications 1 à 4, *caractérisé* **en ce que** la couche de transfert (25) est constituée d'un matériau organique, thermoplastique ou thermodurcissable, intégrant un polymère intrinsèquement conducteur.

10. Dispositif de détection de rayonnements électromagnétiques et de rayonnements ionisants selon la revendication 9, *caractérisé* **en ce que** le matériau organique est composé de polymères sélectionnés dans le groupe comprenant les époxys, les acrylates, les polyuréthanes et les silicones.

11. Dispositif de détection de rayonnements électromagnétiques et de rayonnements ionisants selon l'une des revendications 9 et 10, *caractérisé* **en ce que** le polymère intrinsèquement conducteur est sélectionné dans le groupe comprenant la polyaniline, le polypyrole et le polythiophène.

12. Dispositif de détection de rayonnements électromagnétiques et de rayonnements ionisants selon l'une des revendications 1 à 11, *caractérisé* **en ce que** la couche polymère adhésive électriquement isolante (26) est constituée d'un matériau choisi dans le groupe comprenant les époxys, les acrylates et les silicones.

**Fig. 1**

ART ANTERIEUR

**Fig. 2**

**Fig. 3**

**Fig. 4**

Europäisches
Patentamt

European
Patent Office

Office européen
des brevets

# RAPPORT DE RECHERCHE EUROPEENNE

Numéro de la demande

EP 08 30 5987

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2002/168198 A1 (IMAI SHINJI [JP]) 14 novembre 2002 (2002-11-14) * alinéas [0046] - [0051] * | 1-5,8,9, 11 | INV. H01L27/146 |
| Y | * figures 1-2c * | 6,7,10, 12 | |
| Y | US 2003/215056 A1 (VUORELA MIKKO ILMARI [FI]) 20 novembre 2003 (2003-11-20) * alinéas [0031], [0048], [0061], [0064] * | 6,7,10, 12 | |
| X | EP 1 041 400 A (FUJI PHOTO FILM CO LTD [JP]) 4 octobre 2000 (2000-10-04) * alinéas [0050] - [0055] * * figures 1a-1c * | 1-5,9 | |
| X | US 2005/133744 A1 (IMAI SHINJI [JP]) 23 juin 2005 (2005-06-23) * alinéas [0025] - [0031] * * figures 1-3 * | 1-5,9 | |

DOMAINES TECHNIQUES
RECHERCHES (IPC)

H01L

Le présent rapport a été établi pour toutes les revendications

| Lieu de la recherche | Date d'achèvement de la recherche | Examinateur |
|---|---|---|
| Munich | 23 février 2009 | Markmann, Markus |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.........................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 08 30 5987

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-02-2009

| Document brevet cité au rapport de recherche | | Date de publication | Membre(s) de la famille de brevet(s) | | Date de publication |
|---|---|---|---|---|---|
| US 2002168198 | A1 | 14-11-2002 | EP | 1262797 A2 | 04-12-2002 |
| US 2003215056 | A1 | 20-11-2003 | AUCUN | | |
| EP 1041400 | A | 04-10-2000 | DE | 60032659 T2 | 08-11-2007 |
| | | | JP | 4040201 B2 | 30-01-2008 |
| | | | JP | 2000284056 A | 13-10-2000 |
| | | | US | 6770901 B1 | 03-08-2004 |
| US 2005133744 | A1 | 23-06-2005 | JP | 2005183671 A | 07-07-2005 |

EPO FORM P0460

Pour tout renseignement concernant cette annexe : voir Journal Officiel de l'Office européen des brevets, No.12/82

## RÉFÉRENCES CITÉES DANS LA DESCRIPTION

**Documents brevets cités dans la description**

- US 6396712 B
- JP 5167057 A

- JP 2002334983 A